# EUROPÄISCHE PATENTSCHRIFT

(11) **EP 1 997 137 B1**
(45) Veröffentlichungstag und Bekanntmachung des Hinweises auf die Patenterteilung: **07.05.2014**
(21) Anmeldenummer: 07711796.8
(22) Anmeldetag: 06.03.2007
(51) Int. Cl.: H01L 21/78

(54) **VERFAHREN ZUM HERSTELLEN EINER INTEGRIERTEN SCHALTUNG**
METHOD FOR PRODUCING AN INTEGRATED CIRCUIT
PROCÉDÉ POUR PRODUIRE UN CIRCUIT INTÉGRÉ

(30) Priorität: 14.03.2006 DE 102006013419; 08.12.2006 DE 102006059394
(43) Veröffentlichungstag der Anmeldung: 03.12.2008
(73) Patentinhaber: INSTITUT FÜR MIKROELEKTRONIK STUTTGART, 70569 Stuttgart (DE)
(72) Erfinder: BURGHARTZ, Joachim, N., 70771 Leinfelden-Echterdingen (DE); APPEL, Wolfgang, 71701 Schwieberdingen (DE); ZIMMERMANN, Martin, 70563 Stuttgart (DE)
(74) Vertreter: Duhme, Torsten
(86) Internationale Anmeldenummer: PCT/EP2007/001887
(87) Internationale Veröffentlichungsnummer: WO 2007/104444

(56) Entgegenhaltungen:
- EP-A- 0 957 509
- EP-A- 1 351 292
- US-B2- 6 972 215
- OVERSTOLZ T ET AL: "A clean wafer-scale chip-release process without dicing based on vapor phase etching" MICRO ELECTRO MECHANICAL SYSTEMS, 2004. 17TH IEEE INTERNATIONAL CONFERENCE ON. (MEMS) MAASTRICHT, NETHERLANDS 25-29 JAN. 2004, PISCATAWAY, NJ, USA,IEEE, US, 25. Januar 2004 (2004-01-25), Seiten 717-720, XP010767991 ISBN: 0-7803-8265-X

## Beschreibung

Die vorliegende Erfindung betrifft ein Verfahren zum Herstellen einer integrierten Schaltung, mit den Schritten:
- Bereitstellen eines Halbleiterwafers mit einer ersten und einer zweiten Oberfläche,
- Erzeugen von zumindest einer Schaltungsstruktur in einem definierten Waferabschnitt im Bereich der ersten Oberfläche, und
- Heraustrennen des definierten Waferabschnitts aus dem Halbleiterwafer, wobei der Waferabschnitt in einem ersten Prozessablauf freigestellt wird, so dass er nur noch über lokale, stegartige Verbindungen an einer seitlichen Peripherie des Waferabschnitts an dem verbleibenden Halbleiterwafer gehalten wird, und wobei die stegartigen Verbindungen in einem zweiten Prozessablauf aufgetrennt werden, wobei der erste Prozessschritt die Erzeugung eines Waferhohlraums unter dem definierten Waferabschnitt beinhaltet.

Ein solches Verfahren ist aus EP 1 351 292 A2 bekannt.

Die vorliegende Erfindung betrifft insbesondere ein Verfahren zum Herstellen von sogenannten Chips mit einer integrierten elektronischen Schaltung, wobei die Chips bzw. das Chipmaterial sehr dünn sind. Erfindungsgemäße Chips können eine Dicke von deutlich weniger als 300 µm besitzen, vorteilhafterweise eine Dicke von 50 µm und weniger. Derartig dünne Chips eignen sich gut zur Herstellung von sogenannten 3D-Chips, bei denen mehrere dünne Chips mit jeweils einer integrierten Schaltung aufeinander gestapelt werden. Darüber hinaus besitzen derartig dünne Chips aufgrund der geringen Materialstärke eine gewisse Flexibilität, so dass sie auf flexiblen Trägermaterialien, wie z.B. einer Kunststofffolie, verwendet werden können.

Eine Möglichkeit, um derartig dünne Chips mit einer integrierten Schaltung herzustellen, besteht darin, die integrierte Schaltung zunächst auf einem Halbleiterwafer mit einer Dicke von bspw. 500 µm bis zu 1 mm herzustellen. Nach der Herstellung der integrierten Schaltung wird die Rückseite des Halbleiterwafers durch einen mechanischen und/oder chemischen Prozess abgetragen. Anschließend muss der Halbleiterwafer, der typischerweise eine Vielzahl von integrierten Schaltungen trägt, zu den Chips vereinzelt werden. Herkömmlicherweise geschieht dies durch Sägen, Trennschleifen, Schneiden oder Ritzen und Brechen. Ein Verfahren zum Vereinzeln von Halbleiterwafer zu Chips ist in DE 40 29 973 A1 beschrieben.

Die beschriebene Vorgehensweise besitzt den Nachteil, dass ein erheblicher Teil des Wafermaterials durch den Abtrag ungenutzt verloren geht. Des weiteren müssen relativ große Abstände zwischen den einzelnen Chips auf einem Wafer vorgesehen werden, damit genügend Platz zum Sägen, Trennschleifen etc. zur Verfügung steht. Typische Abstände liegen hier in einer Größenordnung von 500µm bis 1mm. Dies alles wirkt sich nachteilig auf die Kosten für die Herstellung von dünnen integrierten Schaltungen aus, d.h. Chips mit Materialstärken von weniger als 150 µm.

WO 2005/104223 A1 beschreibt ein Verfahren, bei dem an der ersten Oberfläche des Halbleiterwafers zunächst eine Vielzahl von vertikalen Gräben durch einen anisotropen Ätzprozess hergestellt werden. Anschließend wird die geöffnete erste Oberfläche durch eine Epitaxieschicht wieder verschlossen und der Halbleiterwafer wird einer Wärmebehandlung (Annealing) unterzogen. Hierdurch sollen einzelne geschlossene Kanäle unterhalb der ersten Oberfläche gebildet werden. In einem weiteren anisotropen Ätzprozess werden dann vertikale Zugänge zu den verborgenen Kanälen geschaffen. Anschließend werden die Innenwände der Kanäle und der vertikalen Zugänge durch einen Oxidationsprozess mit einer Oxidschicht versehen. Die Kanäle und vertikalen Zugänge umgeben einen Waferabschnitt an der ersten Oberfläche, in dem dann in herkömmlicher Weise eine Schaltungsstruktur erzeugt wird. Daran anschließend wird die Oxidschicht in den Kanälen und vertikalen Zugängen durch einen weiteren Ätzprozess entfernt, so dass der Waferabschnitt nur noch über stegartige Verbindungen an seiner Unterseite mit dem Rest des Wafers verbunden ist. Diese Verbindungen werden aufgebrochen, indem der Waferabschnitt nach oben aus dem verbleibenden Halbleiterwafer herausgerissen wird, wobei ergänzend auch eine Torsionsbewegung vorgeschlagen wird. Mit diesem Verfahren sollen Chips mit einer Dicke von weniger als 10 µm hergestellt werden können.

Nachteilig an diesem Verfahren erscheint dass die Unterseite der vereinzelten Chips eine starke Rauigkeit (verglichen mit der Materialstärke der Chips) aufweisen dürften, weil an der Unterseite des Waferabschnitts unregelmäßige Bruchkanten der ehemaligen stegartigen Verbindungen verbleiben. Außerdem ist das Erzeugen der tiefliegenden Oxidschichten unter dem Waferabschnitt sowie deren späteres, selektives Herausätzen aufwendig und schwierig.

Die eingangs angegebene EP 1 351 292 A2 beschreibt ein Verfahren zum Herstellen einer integrierten Schaltung auf einem SOI-Wafer. Nachdem die integrierte Schaltung hergestellt ist, werden neben der Schaltung Öffnungen in der obenliegenden Siliziumschicht und der darunterliegenden Oxidschicht erzeugt. In diese Öffnungen wird anschließend ein Material eingebracht, welches im nachfolgenden Prozessschritt Stützpfeiler bildet. In diesem nachfolgenden Prozessschritt wird die obenliegende Siliziumschicht erneut geöffnet, um ein Ätzmittel zu der darunterliegenden Oxidschicht zu führen. Die Oxidschicht unter der integrierten Schaltung wird mit dem Ätzmittel entfernt, so dass die integrierte Schaltung über einem Hohlraum "schwebt" und an den Stützpfeilern gehalten ist.

Aus einem Aufsatz von Overstolz et al. mit dem Titel "A Clean Wafer-Scale Chip-Release Process without Dicing Based on Vapor Phase Etching", 17th IEEE International Conference on Micro Electro Mechanical Systems, Januar 2004, Seiten 717 bis 720, ist es bekannt, einen mikromechanischen Sensor, nämlich einen Neigungsmesser, allein durch verschiedene Ätzprozesse aus einem Siliziummaterial herauszulösen. Als Ausgangsmaterial dient ein SOI-Wafer (Silicon on Insulator). Zum Herauslösen des Neigungssensors werden Gräben und Löcher sowohl von der Vorderseite als auch von der Rückseite des Wafermaterials geätzt. Außerdem wird die im Halbleitermaterial liegende Oxidschicht teilweise ausgeätzt, indem ein Flusssäuredampf durch die Löcher an der Vorderseite und Rückseite in das Innere des Halbleiterwafers gebracht wird.

US 6,165,813 beschreibt ein Verfahren zum Lösen von dünnen Chips, die an einem flexiblen Substrat befestigt sind, indem das Substrat gebogen wird. US 6,521,068 beschreibt ein Verfahren zum Vereinzeln von Chips von einem Substrat, wobei ein Bereich unterhalb des Chips mit einem Laser erhitzt wird.

JP 2002-299500 beschreibt die Entnahme von Chips mit Hilfe eines sogenannten Dummy-Substrates.

Schließlich ist im Stand der Technik die Erzeugung und Verwendung von porösem Silizium bekannt. DE 197 52 208 A1 offenbart ein Verfahren zur Herstellung eines Membransensors, wobei eine dünne Schicht aus Siliziumcarbid oder Siliziumnitrit über einen Bereich aus porösem Silizium abgeschieden wird. Das poröse Silizium wird anschließend als Opfermaterial mit Ammoniak entfernt. Dadurch entsteht unter der Membranschicht aus Siliziumcarbid oder Siliziumnitrit ein Hohlraum, der die Sensormembran vom verbleibenden Substrat thermisch entkoppelt.

Des Weiteren wird poröses Silizium beim sog. ELTRAN-Prozess (Epitaxial Layer TRANsfer) verwendet, mit dessen Hilfe SOI-Wafer hergestellt werden. Die Vorgehensweise ist in einer Veröffentlichung von T. Yonehara und K. Sakaguchi beschrieben, die unter dem Titel "ELTRAN; Novel SOI-Wafer Technology" in JSAP International No. 4, Juli 2001 erschienen ist.

Vor diesem Hintergrund ist es eine Aufgabe der vorliegenden Erfindung, ein alternatives Verfahren anzugeben, um dünne integrierte Schaltungen möglichst kostengünstig und mit guter Qualität und Ausbeute herzustellen.

Diese Aufgabe wird gemäß einem Aspekt der vorliegenden Erfindung durch ein Verfahren der eingangs genannten Art gelöst, bei dem ein geschlossener Waferhohlraum mit Hilfe der folgenden Schritte erzeugt wird:
- Bereitstellen eines Substratwafers mit einer Oberseite aus einem ersten Halbleitermaterial, insbesondere einem hoch-p-dotierten Silizium,
- Erzeugen einer Vielzahl von porösen Bereichen in dem ersten Halbleitermaterial, wobei jeder poröse Bereich eine Flächenausdehnung besitzt, die in etwa der Flächenausdehnung des definierten Waferabschnitts entspricht, und
- Erzeugen einer Deckschicht auf der Oberseite, die die porösen Bereiche überdeckt.

Das neue Verfahren unterscheidet sich von dem Verfahren aus der eingangs erwähnten WO 2005/104223 A1 dadurch, dass die tragenden stegartigen Verbindungen, die den Waferabschnitt vor der abschließenden Vereinzelung halten, im Wesentlichen seitlich an dem Waferabschnitt angreifen. Vorzugsweise halten die stegartigen Verbindungen den Waferabschnitt an mehreren gegenüberliegenden Ecken oder Seiten, wobei sie den Waferabschnitt umgeben. In einigen Ausgestaltungen der Erfindung sind die stegartigen Verbindungen an den Ecken eines rechteckigen Waferabschnitts angeordnet. In anderen Ausgestaltungen können die stegartigen Verbindungen an den Längsseiten eines rechteckigen Waferabschnitts sitzen. Darüber hinaus ist die vorliegende Erfindung nicht auf rechteckige Waferabschnitte (und entsprechende Chips) beschränkt. Beispielsweise können stegartige Verbindungen auch am Außenumfang eines in der Grundfläche runden oder elliptischen Waferabschnitts angeordnet sein.

Die vorliegende Erfindung schließt nicht aus, dass einzelne stegartige Verbindungen auch unterhalb des auszulösenden Waferabschnitts bestehen. Dies ist jedoch abhängig von dem Verfahren, mit dem der Waferabschnitt im ersten Prozessablauf freigestellt wird, ein "Resteffekt" (wird weiter unten ausgeführt). In erster Linie wird der Waferabschnitt nach der vorliegenden jedoch von den lokalen, stegartigen Verbindungen an seiner seitlichen Peripherie gehalten.

Durch die neue Art der "Aufhängung" des Waferabschnitts an seiner Peripherie ist es möglich, den Waferabschnitt in den Halbleiterwafer hineinzudrücken, um die stegartigen Verbindungen aufzubrechen. Der Waferabschnitt kann nach dem neuen Verfahren also durch eine Druckkraft von oben aus dem verbleibenden Material des Halbleiterwafers herausgebrochen werden. Im Gegensatz dazu muss bei dem Verfahren nach der eingangs genannten WO 2005/104223 A1 eine Zugkraft aufgebracht werden, und diese Zugkraft muss so stark sein, dass sie die stegartigen Verbindungen in ihrer Längsrichtung auftrennt. Im Gegensatz dazu können bei dem neuen Verfahren Scherkräfte verwendet werden, um die stegartigen Verbindungen aufzutrennen. Berücksichtigt man, dass der Waferabschnitt in bevorzugten Ausgestaltungen der Erfindung sehr dünn ist (Materialstärke kleiner als 150 µm und vorzugsweise im Bereich unter 50 µm), erkennt man, dass die Gefahr einer Beschädigung des Waferabschnitts bei dem neuen Verfahren geringer ist. Darüber hinaus liegen die Trennstellen an der seitlichen Peripherie des Waferabschnitts, die einen gewissen Abstand zu den empfindlichen Schaltungsstrukturen in dem Waferabschnitt aufweisen kann. Demgegenüber liegen die gewaltsam aufgebrochenen Trennstellen bei dem bekannten Verfahren direkt unterhalb der empfindlichen Schaltungsstrukturen.

Mit der vorliegenden Erfindung lässt sich daher das Risiko, das der Waferabschnitt beim Vereinzeln beschädigt wird, deutlich reduzieren. Darüber hinaus kann das Vereinzeln in bevorzugten Ausgestaltungen auf sehr kostengünstige Weise mit bekannten Vorrichtungen ausgeführt werden, die zur Handhabung und Bestückung von SMD-Bauelementen (Surface Mounted Devices) verwendet werden.

Darüber hinaus besitzt das neue Verfahren den Vorteil, dass der verbleibende Halbleiterwafer erneut zur Herstellung von integrierten Schaltungen verwendet werden kann, wenn man die verbleibenden Stegreste an der ersten Oberfläche abschleift. Damit wird der Halbleiterwafer optimal genutzt. Die Herstellungskosten für dünne integrierte Schaltungen lassen sich reduzieren.

Schließlich besitzt das neue Verfahren den Vorteil, dass die Unterseite der Waferabschnitte (zumindest weitgehend) frei von Bruchstellen und Artefakten ist, wodurch der Waferabschnitt bzw. der Chip leichter und exakter weiterverarbeitet werden kann, bspw. beim Aufeinanderstapeln für einen 3D-Chip oder beim Anordnen auf einer dünnen Folie.

Die Realisierung des neuen Verfahrens mit einem geschlossenen Hohlraum besitzt den Vorteil, dass der Halbleiterwafer trotz Hohlraum (bzw. mit einer Vielzahl solcher Hohlräume für eine Vielzahl solcher Waferabschnitte) auf Lager bevorratet werden kann, wodurch der Produktionsprozess weiter rationalisiert und noch kostengünstiger gemacht werden kann.

Vorzugsweise überdeckt die Deckschicht die gesamte Oberfläche des Halbleiterwafers, so dass der Halbleiterwafer von außen kaum oder gar nicht von einem Halbleiterwafer ohne Hohlräume zu unterscheiden ist.

Mit dieser Ausgestaltung lassen sich geeignete Waferhohlräume sehr kostengünstig erzeugen. Diese Ausgestaltung ist daher besonders vorteilhaft für eine Massenfertigung von integrierten Schaltungen.

Insgesamt ermöglicht das neue Verfahren somit eine kostengünstige und qualitativ hochwertige Herstellung von dünnen integrierten Schaltungen. Die eingangs genannte Aufgabe ist daher vollständig gelöst.

Wie bereits erwähnt, werden die stegartigen Verbindungen in einer bevorzugten Ausgestaltung des Verfahrens mit Hilfe eines Drucks von oben auf die erste Oberfläche aufgebrochen. Alternativ oder ergänzend hierzu können die stegartigen Verbindungen auch mit Hilfe einer Torsionsbewegung aufgebrochen werden.

Diese Ausgestaltung ermöglicht die Handhabung der Waferabschnitte mit Hilfe von Greifwerkzeugen, wie sie auch zur Handhabung von SMD-Bauelementen verwendet werden. Damit ist eine besonders kostengünstige und rationelle Herstellung von dünnen Chips möglich.

In einer weiteren Ausgestaltung wird jeder poröse Bereich mit einer großporigen unteren Schicht und einer feinporigen oberen Schicht erzeugt.

Die Eindringtiefe und Porengröße der Schichten kann beim Herstellen der porösen Bereiche variiert werden, indem bspw. die Stromdichte eines Stroms variiert wird, der durch eine Lösung aus Flusssäure und Ethanol fließt, in der der Substratwafer aus einkristallinem Silizium als Anode angeordnet ist (vgl. die eingangs erwähnte Veröffentlichung von Yonehara/Sakaguchi). Indem man eine großporige untere Schicht und eine feinporige obere Schicht erzeugt, lässt sich der Waferhohlraum einfacher nach oben verschließen. Unten sorgt eine großporige untere Schicht dafür, dass der Waferabschnitt möglichst frei über dem restlichen Wafermaterial "schwebt". Je größer die Porengröße hier ist, desto weniger ist der Waferabschnitt mit dem darunter liegenden Wafermaterial verbunden.

In einer weiteren Ausgestaltung wird der Substratwafer nach dem Erzeugen der porösen Bereiche aufgeheizt, um die Deckschicht zu erzeugen.

In dieser Ausgestaltung wird der Substratwafer nach dem Erzeugen der porösen Bereiche einer Wärmebehandlung (Annealing) unterzogen. Hierdurch schließen sich die Poren an der Oberseite. Außerdem kann so die Porengröße in den tieferliegenden Bereichen noch vergrößert werden. Es findet eine Art Reflow-Prozess statt, mit dessen Hilfe das (bevorzugt feinporige) Material an der Oberseite wieder in eine einkristalline Struktur umgeformt wird. Das dazu erforderliche Material stammt aus der tieferliegenden, vorzugsweise großporigen Schicht. Diese Ausgestaltung ist besonders vorteilhaft, um einen geeigneten Hohlraum auf kostengünstige Weise zu erzeugen.

In einer weiteren Ausgestaltung wird auf die Oberseite ein zweites Halbleitermaterial aufgebracht, um die Deckschicht zu erzeugen. In bevorzugten Ausführungen der Erfindung wird eine Epitaxieschicht auf die oberste kristalline Lage aufgewachsen, die durch den gerade beschriebenen Reflow-Prozess über dem Hohlraum erzeugt wurde.

Diese Ausgestaltung erleichtert die spätere Herstellung der Schaltungsstrukturen in dem Waferabschnitt, weil die Schaltungsstrukturen in einem "normalen" einkristallinen Halbleitermaterial erzeugt werden können. Daher lässt sich das neue Verfahren in dieser Ausgestaltung besonders einfach in bestehende Produktionsprozesse integrieren.

In einer weiteren Ausgestaltung weist der Substratwafer ein drittes Halbleitermaterial auf, vorzugsweise ein geringer p-dotiertes Halbleitermaterial (zum Beispiel Silizium), das unter dem ersten Halbleitermaterial (vorzugsweise hoch-p-dotiertes Silizium) angeordnet ist, wobei die porösen Bereiche nur in dem ersten Halbleitermaterial erzeugt werden.

Diese Ausgestaltung ist besonders vorteilhaft, um eine möglichst ebene Oberfläche über den Hohlräumen zu erhalten. Für die Herstellung der porösen Schichten ist es nämlich von Vorteil, ein hoch-p-dotiertes Silizium zu verwenden. Demgegenüber werden für die Schaltungsstruktur häufig weniger hochdotierte Bereiche benötigt. Es ist daher von Vorteil, die bereits erwähnte Epitaxieschicht auf der Oberseite des Halbleiterwafers aufzubringen. Unterschiedliche hohe Dotierungen können jedoch Spannungen im Material aufgrund von unterschiedlichen Gitterkonstanten hervorrufen. Diese Spannungen können zur Folge haben, dass die Oberfläche des Halbleiterwafers wellig wird. Indem man nun die porösen Bereiche in einer hochdotierten Schicht erzeugt, die auf einem dritten Halbleitermaterial angeordnet ist, kann man durch geeignete Wahl der Prozessparameter dafür Sorge tragen, dass die Gitterkonstanten der Materialien nach dem Herstellen der porösen Schicht besser aneinander angepasst sind. Hierdurch lassen sich Spannungen und daraus folgende Welligkeiten zumindest reduzieren.

In einer weiteren Ausgestaltung der Erfindung wird der Waferabschnitt in dem ersten Prozessablauf von der zweiten Oberfläche her freigestellt.

In dieser Ausgestaltung wird Material unterhalb des herauszulösenden Waferabschnitts von unten, also von der zweiten Oberfläche her, abgetragen. Dies kann in Ergänzung zu einem Hohlraum unter dem Waferabschnitt geschehen. Bevorzugt wird diese Ausgestaltung jedoch ohne Hohlraum unter dem Waferabschnitt realisiert. Besonders bevorzugt wird diese Ausgestaltung des Verfahrens mit einem SOI-Wafer realisiert, wobei der Waferabschnitt mit den Schaltungsstrukturen in der oberen Halbleiterschicht des SOI-Wafers ausgebildet wird und wobei die untere Materiallage (Bulk-Silizium) vor oder nach der Erzeugung der Schaltungsstrukturen herausgeätzt wird.

Diese Ausgestaltung ist besonders vorteilhaft, um eine sehr glatte Oberfläche an der Unterseite des Waferabschnitts zu erhalten. Dementsprechend eignet sich diese Ausgestaltung besonders für Anwendungen, die sehr hohe Anforderungen an die Oberflächenqualität der Rückseite des vereinzelten Chips stellen. Gleichwohl macht auch diese Ausgestaltung von den grundsätzlichen Vorteilen des neuen Verfahrens Gebrauch, insbesondere der Möglichkeit, die Chips mit Hilfe von herkömmlichen SMD-Greifwerkzeugen zu vereinzeln und weiterzuverarbeiten.

In einer weiteren Ausgestaltung beinhaltet der erste Prozessablauf die Erzeugung von Gräben an der ersten Oberfläche des Halbleiterwafers, nachdem die Schaltungsstruktur in dem Waferabschnitt erzeugt wurde.

In dieser Ausgestaltung kann der erste Prozessablauf zweigeteilt sein, indem er zumindest zwei zeitlich voneinander getrennte Stufen beinhaltet. Dies ist beispielsweise der Fall, wenn der Waferabschnitt mit Hilfe eines Hohlraums freigestellt wird, der vorteilhafterweise erzeugt wird, bevor die Schaltungsstrukturen in dem Waferabschnitt hergestellt werden. Demgegenüber werden die Gräben nach dieser Ausgestaltung des Verfahrens erst nach dem Herstellen der Schaltungsstruktur geätzt oder anderweitig erzeugt. Die vorliegende Ausgestaltung ist jedoch auch in den alternativen Varianten des neuen Verfahrens von Vorteil, in denen auf einen Hohlraum verzichtet wird. Generell besitzt die Ausgestaltung den Vorteil, dass die Herstellung der integrierten Schaltung einfacher und damit kostengünstiger in bestehende Fertigungsabläufe integriert werden kann, da der Halbleiterwafer beim Herstellen der Schaltungsstrukturen eine (zumindest weitgehend) geschlossene Oberfläche besitzt.

In einer weiteren Ausgestaltung wird der Waferabschnitt in dem Halbleiterwafer in [100]-Ausrichtung oder in (110)-Ausrichtung angeordnet und die stegartigen Verbindungen werden an den Ecken oder an den Seitenkanten des Waferabschnitts angeordnet.

Weil insbesondere das Brechverhalten von Halbleiterwafern in Abhängigkeit von der Lage einer Bruchkante relativ zum Kristallgitter unterschiedlich ist, kann man durch diese Ausgestaltung die zum Auftrennen der Verbindungen erforderlichen Kräfte und auch die Ausbildung der Trennstellen beeinflussen. Mit den bevorzugten Ausgestaltungen lässt sich eine optimale Auslösung des Waferabschnitts erreichen.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ausführungsbeispiele der Erfindung sind in der Zeichnung dargestellt und werden in der nachfolgenden Beschreibung näher erläutert. Es zeigen:
- Fig. 1: eine vereinfachte, schematische Darstellung zur Erläuterung eines ersten Ausführungsbeispiels des neuen Verfahrens,
- Fig. 2: eine vereinfachte Darstellung zur Erläuterung einer Variante des Verfahrens, bei der ein Waferhohlraum unter dem Waferabschnitt erzeugt wird, und
- Fig. 3: eine schematische Darstellung der Vereinzelung der Chips in einem Ausführungsbeispiel des neuen Verfahrens.

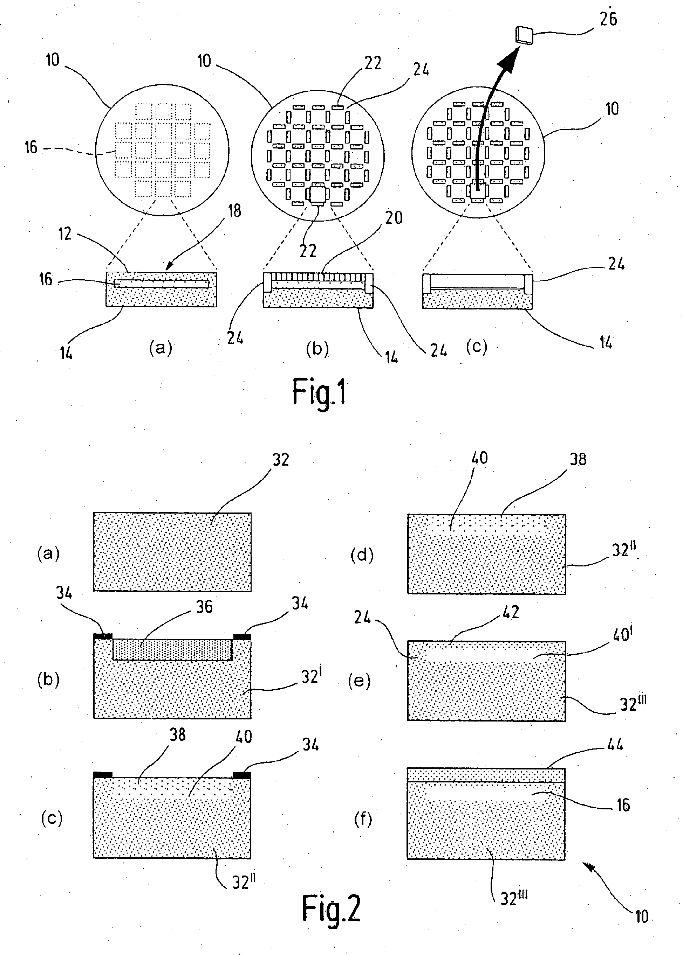

In Fig. 1 ist ein Halbleiterwafer mit der Bezugsziffer 10 bezeichnet. Der Halbleiterwafer 10 besitzt eine erste Oberfläche 12 und eine gegenüberliegende zweite (untere) Oberfläche 14. Unterhalb der ersten Oberfläche 12 ist ein Hohlraum 16 angeordnet, so dass ein Waferabschnitt 18 oberhalb des Hohlraums "hängend" gelagert ist. Wie in Fig. 1a) dargestellt ist, besitzt der Halbleiterwafer eine Vielzahl solcher Hohlräume 16, die im Inneren des Halbleitermaterials verborgen sind.

In einem ersten Ausführungsbeispiel der Erfindung wird ein solcher Halbleiterwafer 10 bereitgestellt (Fig. 1a). Anschließend wird in den Waferabschnitten 18 oberhalb der Hohlräume 16 jeweils eine Schaltungsstruktur in herkömmlicher Weise erzeugt. Die Schaltungsstruktur ist in Fig. 1b bei der Bezugsziffer 20 schematisch angedeutet. Sie liegt in bevorzugten Ausführungsbeispielen in [100]- oder [110]-Richtung bezogen auf das Kristallgitter des Wafermaterials. Der Waferabschnitt 18 mit der Schaltungsstruktur 20 bildet einen zukünftigen Chip mit einer integrierten Schaltung, der nun aus dem Halbleiterwafer 10 herausgelöst werden muss.

Dies geschieht in dem gezeigten Ausführungsbeispiel dadurch, dass eine Vielzahl von Gräben 22 in die Oberfläche 12 des Halbleiterwafers 10 hineingeätzt werden, wobei die einzelnen Gräben 22 durch stegartige Bereiche 24 voneinander getrennt sind. In dem bevorzugten Ausführungsbeispiel sind die Gräben 22 gitterartig auf der Oberfläche 12 des Halbleiterwafers 10 verteilt und sie bilden ein Muster aus senkrechten und waagerechten Gräben. Dort, wo ein senkrechter und ein waagerechter Graben 22 zusammentreffen, ist ein stegartiger Bereich 24 verblieben, der nicht ausgeätzt wurde. Jeweils vier Gräben umgeben einen Waferabschnitt 18 mit der integrierten Schaltungsstruktur 20. Dementsprechend ist hier jeder Waferabschnitt 18 nur noch an seinen vier Ecken durch die stegartigen Verbindungen 24 gehalten. Alternativ könnten die Waferabschnitte 18 auch über stegartige Verbindungen gehalten werden, die nicht an den Ecken, sondern zum Beispiel mittig an den Seitenkanten jedes Waferabschnitts 18 angeordnet sind.

Wie in Fig. 1c dargestellt ist, können die einzelnen Waferabschnitte 18 aus dem Gitterraster der Gräben 22 herausgebrochen werden, und man erhält auf diese Weise Chips 26 mit einer integrierten Halbleiterstruktur.

Fig. 2 zeigt ein bevorzugtes Ausführungsbeispiel, um einen Halbleiterwafer 10 nach Fig. 1 herzustellen. Gemäß Fig. 2a wird zunächst ein Substratwafer 32 bereitgestellt, der bspw. aus einkristallinem, schwach p-dotierten Silizium besteht. Gemäß Fig. 2b wird der Substratwafer 32 mit einer Photomaske 34 versehen und belichtet. Die Photomaske 34 bedeckt die Oberfläche des Substratwafers 32 nur teilweise und die offenen Stellen können in bekannter Art und Weise bearbeitet werden.

In dem dargestellten Ausführungsbeispiel wird der Substratwafer 32 durch die Maske 34 hindurch p-dotiert, um einen hoch-p-dotierten Halbleiterbereich 36 zu erhalten. Das darunter liegende Substratmaterial 32' weist weiterhin nur eine geringere p-Dotierung auf.

Gemäß Fig. 2c werden anschließend poröse Schichten 38, 40 in dem hochdotierten Halbleitermaterial 36 erzeugt. Dazu wird der Substratwafer in einem bevorzugten Ausführungsbeispiel als Anode in eine Lösung aus Flusssäure und Ethanol gegeben, so dass ein Strom durch die Lösung zu dem Substratwafer fließen kann. Hierdurch bildet sich poröses Silizium im Bereich des hochdotierten Halbleitermaterials 36, wobei die Porengröße durch Variation der Stromdichte verändert werden kann. In dem bevorzugten Ausführungsbeispiel wird eine feinporige Schicht 38 an der Oberfläche des Substratwafers und eine großporige Schicht 40 darunter erzeugt. Eine etwas genauere Beschreibung der Herstellung dieser Schichten ist in der eingangs erwähnten Veröffentlichung von Yonehara/Sakaguchi enthalten, auf die hier ausdrücklich Bezug genommen ist.

Gemäß Fig. 2d wird die Photomaske 34 anschließend entfernt und der Wafer 32" mit den porösen Schichten 38, 40 wird einer Wärmebehandlung ausgesetzt. Dies hat zur Folge, dass sich die Poren in der oberen feinporigen Schicht 38 zumindest teilweise wieder schließen und die obere Schicht 38 wieder in eine weitgehend gleichmäßige, einkristalline Schicht 42 umgeformt wird, unter der die großporige Schicht 40' liegt, deren Porengröße sich noch vergrößert hat. Die großporige Schicht 40 bildet nun den Hohlraum, der in Fig. 1 mit der Bezugsziffer 16 bezeichnet ist. Innerhalb dieses Hohlraums können noch vereinzelte Stege (hier nicht dargestellt) verblieben sein, die die obere Schicht 42 mit dem unten liegenden Substratmaterial 32'" verbinden. Derartige Stege sind jedoch die Folge von Prozessschwankungen und praktischen Unzulänglichkeiten beim Erzeugen des Hohlraums 16. Gehalten wird der Waferabschnitt 18 aus Fig. 1 in erster Linie durch die seitlich neben dem Hohlraum 16 verbliebenen Stege 24, die aufgrund der Maskenstruktur 34 stehen geblieben sind.

Gemäß Fig. 2f wird als Nächstes eine weitere Schicht 44 als Deckschicht auf die Oberfläche des Substratmaterials 32"' aufgebracht. In einem bevorzugten Ausführungsbeispiel handelt es sich hier um eine Epitaxieschicht aus einkristallinem, mäßig p-dotierten Silizium; die auf der Schicht 42 bzw. auf der gesamten Oberfläche des Halbleiterwafers aufgewachsen wird. Damit erhält man einen Halbleiterwafer 10, der für die Prozessschritte gemäß Fig. 1 als Ausgangsmaterial bereitgestellt wird.

Wie aus der Zusammenschau der Figuren 1 und 2 zu ersehen ist, entspricht die laterale Flächenausdehnung der porösen Schichten 38, 40 in etwa der lateralen Flächenausdehnung des Hohlraums 16 und insofern auch in etwa der lateralen Flächenausdehnung des Waferabschnitts 18, in dem die Schaltungsstruktur 22 erzeugt wird. Damit bestimmt die laterale Flächenausdehnung der porösen Schichten 38, 40 auch die Chipfläche des späteren Chips 26.

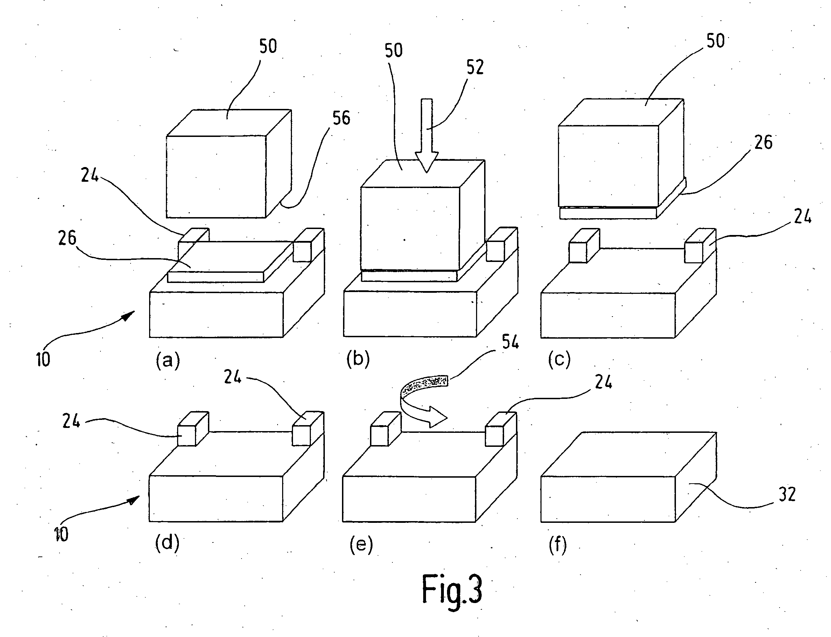

Fig. 3 zeigt ein bevorzugtes Ausführungsbeispiel zum Vereinzeln der Chips 26. Hiernach werden die einzelnen Chips mit Hilfe eines Greifwerkzeug 50 erfasst, das die Chips 26 (genauer: die Waferabschnitte 18, die noch an den stegartigen Verbindungen 24 hängen) mit Vakuum ansaugt. Durch einen Druck von oben (Pfeil 52) werden die stegartigen Verbindungen 24 aufgebrochen, indem der einzelne Chip 26 nach unten in den Hohlraum gedrückt wird. Anschließend kann der Chip 26 mit dem Greifwerkzeug 50 nach oben abgenommen werden und weiterverarbeitet werden. Alternativ oder ergänzend kann der Chips 26 auch durch Zugkräfte und/oder Torsionskräfte aus dem Wafer 10 heraus gebrochen werden.

Zu den Vorteilen des in Fig. 1 und 2 dargestellten Verfahrens gehört es, dass der verbleibende Halbleiterwafer 10 nach der Entnahme aller Chips 26 recycelt werden kann. Hierzu wird der Halbleiterwafer 10 mit den verbliebenen Stegbereichen 24 (Fig. 3d) an seiner Oberseite abgeschliffen und poliert, wie dies in Fig. 3e bei der Bezugsziffer 54 symbolisch dargestellt ist. Damit erhält man einen (etwas dünneren) Substratwafer 32, der erneut der Prozessabfolge aus Fig. 2 unterzogen werden kann.

Wie in Fig. 3 dargestellt ist, ergreift das Greifwerkzeug 50 die einzelnen Chips 26 weitgehend deckungsgleich. Dementsprechend ist das Greifwerkzeug 50 im Bereich seiner unteren Greiffläche 56 in etwa genauso groß ausgebildet wie die laterale Flächenausdehnung des Chips 26. Hierdurch kann das Greifwerkzeug 50 die empfindlichen Chips 26 sicher halten. Das Risiko von Beschädigungen beim Herausbrechen aus dem Halbleiterwafer 10 wird weiter minimiert.

## Patentansprüche

1. Verfahren zum Herstellen einer integrierten Schaltung, mit den Schritten:
- Bereitstellen eines Halbleiterwafers (10; 60) mit einer ersten und einer zweiten Oberfläche (12, 14),
- Erzeugen von zumindest einer Schaltungsstruktur (20) in einem definierten Waferabschnitt (18) im Bereich der ersten Oberfläche (12), und
- Heraustrennen des definierten Waferabschnitts (18) aus dem Halbleiterwafer (10; 60), wobei der Waferabschnitt (18) in einem ersten Prozessablauf freigestellt wird, so dass er nur noch über lokale, stegartige Verbindungen (24) an einer seitlichen Peripherie des Waferabschnitts (18) an dem verbleibenden Halbleiterwafer (10; 60) gehalten wird, und wobei die stegartigen Verbindungen (24) in einem zweiten Prozessablauf aufgetrennt werden,
wobei der erste Prozessschritt die Erzeugung eines Waferhohlraums (16) unter dem definierten Waferabschnitt (18) beinhaltet, und wobei die Schaltungsstruktur über dem Waferhohlraums erzeugt wird,
**dadurch gekennzeichnet, dass** ein geschlossener Waferhohlraum (16) mit Hilfe der folgenden Schritte erzeugt wird:
- Bereitstellen eines Substratwafers (32') mit einer Oberseite aus einem ersten Halbleitermaterial (36),
- Erzeugen einer Vielzahl von porösen Bereichen (38, 40) in dem ersten Halbleitermaterial (36), wobei jeder poröse Bereich (38, 40) eine Flächenausdehnung besitzt, die in etwa der Flächenausdehnung des definierten Waferabschnitts (18) entspricht, und
- Erzeugen einer Deckschicht (42, 44) auf der Oberseite, die die porösen Bereiche (38, 40) überdeckt.

2. Verfahren nach Anspruch 1, **dadurch gekennzeichnet, dass** die stegartigen Verbindungen (24) mit Hilfe eines Drucks (52) von oben auf die erste Oberfläche (12) aufgebrochen werden.

3. Verfahren nach einem der Ansprüche 1 bis 2, **dadurch gekennzeichnet, dass** jeder poröse Bereich mit einer großporigen unteren Schicht (40) und einer feinporigen oberen Schicht (38) erzeugt wird.

4. Verfahren nach einem der Ansprüche 1 bis 3, **dadurch gekennzeichnet, dass** der Substratwafer (32") nach dem Erzeugen der porösen Bereiche (38, 40) aufgeheizt wird, um die Deckschicht (42) zu erzeugen.

5. Verfahren nach einem der Ansprüche 1 bis 4, **dadurch gekennzeichnet, dass** ein zweites Halbleitermaterial (44) auf die Oberseite aufgebracht wird, um die Deckschicht zu erzeugen.

6. Verfahren nach einem der Ansprüche 1 bis 5, **dadurch gekennzeichnet, dass** der Substratwafer (32') ein drittes Halbleitermaterial (32) aufweist, das unter dem ersten Halbleitermaterial (36) angeordnet ist, wobei die porösen Bereiche (38, 40) nur in dem ersten Halbleitermaterial (36) erzeugt werden.

7. Verfahren nach einem der Ansprüche 1 bis 6, **dadurch gekennzeichnet, dass** der Waferabschnitt (18) in dem ersten Prozessablauf von der zweiten Oberfläche (14) her freigestellt wird.

8. Verfahren nach einem der Ansprüche 1 bis 7, **dadurch gekennzeichnet, dass** der erste Prozessablauf die Erzeugung von Gräben (22) an der ersten Oberfläche (12) beinhaltet, nachdem die Schaltungsstruktur (20) in dem Waferabschnitt (18) erzeugt wurde.

9. Verfahren nach einem der Ansprüche 1 bis 8, **dadurch gekennzeichnet, dass** der Waferabschnitt (18) in dem Halbleiterwafer in [100]-Richtung oder in [110]-Richtung angeordnet wird und dass die stegartigen Verbindungen (24) an Ecken oder an Seitenkanten des Waferabschnitts (18) angeordnet werden.

## Claims

1. A method for producing an integrated circuit, comprising the following steps:
- providing a semiconductor wafer (10; 60) having a first and a second surface (12, 14),
- producing at least one circuit structure (20) in a defined wafer section (18) in the region of the first surface (12), and
- releasing the defined wafer section (18) from the semiconductor wafer (10; 60), wherein the wafer section (18) is freed in a first process sequence, such that it is held only via local web-like connections (24) arranged at a lateral periphery of the wafer section (18) on the remaining semiconductor wafer (10; 60), and wherein the web-like connections (24) are severed in a second process sequence,
wherein the first process sequence comprises producing a closed wafer cavity (16) below the defined wafer section (18), and wherein the circuit structure is produced above the wafer cavity,
**characterized in that** a closed wafer cavity (16) is produced by means of the following steps:
- providing a substrate wafer (32') having a top side composed of a first semiconductor material (36),
- producing a plurality of porous regions (38, 40) in the first semiconductor material (36), wherein each porous region (38, 40) has an area extent corresponding approximately to the area extent of the defined wafer section (18), and
- producing a cover layer (42, 44) on the top side, which covers the porous regions (38, 40).

2. The method of claim 1, **characterized in that** the web-like connections (24) are broken by means of a pressure (52) applied from above on the first surface (12).

3. The method of any of claims 1 to 2, **characterized in that** each porous region is produced with a large-pored lower layer (40) and a fine-pored upper layer (38).

4. The method of any of claims 1 to 3, **characterized in that** the substrate wafer (32") is heated after the porous regions (38, 40) have been produced, in order to produce the cover layer (42).

5. The method of any of claims 1 to 4, **characterized in that** a second semiconductor material (44) is applied to the top side in order to produce the cover layer.

6. The method of any of claims 1 to 5, **characterized in that** the substrate wafer (32') comprises a third semiconductor material (32), which is arranged below the first semiconductor material (36), wherein the porous regions (38, 40) are produced only in the first semiconductor material (36).

7. The method of any of claims 1 to 6, **characterized in that** the wafer section (18) is freed from the second surface (14) in the first process sequence.

8. The method of any of claims 1 to 7, **characterized in that** the first process sequence comprises producing trenches (22) at the first surface (12) after the circuit structure (20) has been produced in the wafer section (18).

9. The method of any of claims 1 to 8, **characterized in that** the wafer section (18) is arranged in the [100] direction or in the [110] direction in the semi-conductor water, and the web-like connections (24) are arranged at corners or at lateral edges of the wafer section (18).

## Revendications

1. Procédé de fabrication d'un circuit intégré, le procédé présentant les étapes qui consistent à :
- préparer une galette semi-conductrice (10; 60) qui présente une première et une deuxième face (12, 14),
- former au moins une structure de circuit (20) dans une partie définie (18) de la galette au niveau de la première face (12) et
- enlever la partie définie (18) de la galette semi-conductrice (10; 60), la partie (18) de la galette étant libérée dans une première succession de traitements de telle sorte qu'elle ne soit plus maintenue sur le reste de la galette semi-conductrice (10; 60) que par des liaisons locales (24) en forme d'entretoise situées sur la périphérie latérale de la partie (18) de la galette, les liaisons (24) en forme d'entretoise étant découpées dans une deuxième succession de traitements,
la première étape de traitement contenant la formation d'une cavité (16) en dessous de la partie définie (18) de la galette,
la structure de circuit étant formée au-dessus de la cavité de la galette,
**caractérisé en ce que** une cavité fermée (16) est formée dans la galette à l'aide des étapes suivantes:
- préparer une galette (32') de substrat dotée d'un côté supérieur en un premier matériau semi-conducteur (36),
- former plusieurs zones poreuses (38, 40) dans le premier matériau semi-conducteur (36), chaque zone poreuse (38, 40) présentant une extension en surface qui correspond sensiblement à l'extension en surface de la partie définie (18) de la galette et
- former une couche de recouvrement (42, 44) sur le côté supérieur qui recouvre les zones poreuses (38, 40).

2. Procédé selon la revendication 1, **caractérisé en ce que** les liaisons (24) en forme d'entretoise sont rompues en exerçant une poussée (52) depuis le haut sur la première surface (12).

3. Procédé selon l'une des revendications 1 et 2, **caractérisé en ce que** chaque zone poreuse est configurée avec une couche inférieure (40) à porosité grossière et une couche supérieure (38) à porosité fine.

4. Procédé selon l'une des revendications 1 à 3, **caractérisé en ce que** pour former la couche de recouvrement (42), la galette (32") de substrat est chauffée après la formation des zones poreuses (38, 40).

5. Procédé selon l'une des revendications 1 à 4, **caractérisé en ce que** pour former la couche de recouvrement, un deuxième matériau semi-conducteur (44) est appliqué sur le côté supérieur.

6. Procédé selon l'une des revendications 1 à 5, **caractérisé en ce que** la galette (32') de substrat présente un troisième matériau semi-conducteur (32) disposé en dessous du premier matériau semi-conducteur (36), les zones poreuses (38, 40) n'étant formées que dans le premier matériau semi-conducteur (36).

7. Procédé selon l'une des revendications 1 à 6, **caractérisé en ce que** la partie (18) de la galette est libérée de la deuxième surface (14) au cours de la première succession de traitements.

8. Procédé selon l'une des revendications 1 à 7, **caractérisé en ce que** la première succession d'opérations contient la formation de sillons (22) sur la première surface (12) après que la structure de circuit (20) a été formée dans la partie (18) de la galette.

9. Procédé selon l'une des revendications 1 à 8, **caractérisé en ce que** la partie (18) de la galette est disposée dans la galette semi-conductrice dans la direction [100] ou dans la direction [110] et **en ce que** les liaisons (24) en forme d'entretoise sont disposées sur les sommets ou sur les bords latéraux de la partie (18) de la galette.
